# EUROPÄISCHE PATENTSCHRIFT

(11) **EP 3 092 551 B1**
(45) Veröffentlichungstag und Bekanntmachung des Hinweises auf die Patenterteilung: **14.03.2018**
(21) Anmeldenummer: 15702381.3
(22) Anmeldetag: 07.01.2015
(51) Int. Cl.: G06F 3/044

(54) **KAPAZITIVES SENSORELEMENT SOWIE VERFAHREN ZUR HERSTELLUNG DAZU**
CAPACITIVE SENSOR ELEMENT AND CORRESPONDING MANUFACTURING METHOD
ELEMENT DE DETECTION CAPACITIF ET PROCÉDÉ POUR PRODUIRE UN TEL ELEMENT

(30) Priorität: 10.01.2014 DE 102014100246
(43) Veröffentlichungstag der Anmeldung: 16.11.2016
(73) Patentinhaber: PolyIC GmbH & Co. KG, 90763 Fürth (DE)
(72) Erfinder: ULLMANN, Andreas, 90513 Zirndorf (DE); FIX, Walter, 90763 Fürth (DE); WALTER, Manfred, 90419 Nürnberg (DE)
(74) Vertreter: Zinsinger, Norbert
(86) Internationale Anmeldenummer: PCT/EP2015/050175
(87) Internationale Veröffentlichungsnummer: WO 2015/104295

(56) Entgegenhaltungen:
- EP-A2- 2 544 080
- WO-A1-2013/063188
- WO-A2-2005/114369
- CN-A- 103 207 719
- US-A1- 2013 301 196

## Beschreibung

Die Erfindung betrifft ein kapazitives Sensorelement mit einer Vielzahl von Sensorfeldern, wie sie beispielsweise der Anordnung auf einem Berührungsbildschirm entsprechen. Dieses kapazitive Sensorelement umfasst zumindest einen Mehrschichtkörper aus zwei strukturierten elektrisch leitfähigen Schichten und dazwischen eine Isolatorschicht. Außerdem betrifft die Erfindung ein Verfahren zur Herstellung eines solchen Sensorelements.

Derartige kapazitive Sensorelemente sind aus der DE 10 2011 115 851 A1 bekannt. Die dort offenbarten Sensorelemente umfassen beispielsweise nach dem "bar and stripe" Prinzip angeordnete Leitfähigkeitsbänder als Elektroden. Dabei liegen beispielsweise auf einer ersten, unteren elektrisch leitfähigen Schicht breite Leitfähigkeitsbänder "bars" oder Bar-Elektroden, die - wiederum beispielsweise - in x-Richtung verlaufen und auf einer zweiten, über der ersten angeordneten, elektrisch leitfähigen Schicht schmale Leitfähigkeitsbänder "stripes" oder Stripe-Elektroden, die in y-Richtung verlaufen. Die beiden elektrisch leitfähigen Schichten sind durch eine Isolatorschicht galvanisch getrennt. An den Kreuzungspunkten von bars und stripes bilden sich Berührungssensorfelder, so genannte Touchfelder, aus.

Die unterschiedliche geometrische Ausbildung der Elektroden als bars und stripes ist wegen des Verlaufs der elektrischen Feldlinien zwischen den Leitfähigkeitsbändern der ersten und zweiten elektrisch leitfähigen Schicht günstig. Durch die Ausbildung der zweiten elektrisch leitfähigen Schicht als "stripe" gibt es viele Feldlinien, die im Raum oberhalb des Sensorelements verlaufen und die durch die Berührung mit dem Eingabeelement gestört werden. Die Störung des Feldlinienverlaufs entspricht der Eingabe und wird durch eine größere Anzahl an gestörten Feldlinien zuverlässiger erfassbar. Aus der WO 2005/114369 ist es zudem bekannt sogenannte "dummy lines", also nicht mit Anschlussleitungen verbundene Elektroden, vorzusehen. Diese sind zwischen den SensorElektroden angebracht, und zwar zur Verbesserung der optischen Einheitlichkeit. Nach den bisher bekannten Layouts für die elektrisch leitfähigen Schichten eines kapazitiven Sensorelements, wie beispielsweise dem aus der DE10 2011 115 851 A1 bekannten Layout, ist es für das Auslesen der Eingabesignale unerlässlich, dass die erste und zweite elektrisch leitfähige Schicht passgenau übereinander liegen. Es sind Anschlussleitungen an den Bar- und Stripe-Elektroden vorgesehen, die über entsprechende Stecker in einem Randbereich des das Sensorelement umfassenden Moduls die Signale von den Sensorfeldern weiterleiten, so dass eine Eingabe eindeutig zugeordnet und zuverlässig ausgelesen werden kann.

Als "Modul" wird hier beispielsweise ein Smartphone, ein I-Pad oder ein sonstiger Berührungsbildschirm bezeichnet. Das Sensorelement bildet zumindest einen Teil des Eingabebereichs eines Berührungsbildschirms und ist bevorzugt transparent ausgebildet.

Die Anschlussleitungen passen in Stecker, die im Randbereich des Sensorelements vorgegeben sind. Damit die Stecker auch zuverlässig mit den Anschlussleitungen bei der Montage kontaktieren und somit alle Eingaben über die Anschlussleitungen auslesbar sind, ist es erforderlich oder zumindest vorteilhaft für die Zuverlässigkeit des Sensorelements, dass die elektrisch leitfähigen Schichten bei der Montage des Sensorelements passgenau übereinander gelegt werden. Insbesondere ist es vorteilhaft, dass die Lage der beiden elektrisch leitfähigen Schichten beispielsweise um weniger als 200 µm, besser noch um weniger als 100µm von ihrem theoretisch zugewiesenen Platz, an dem die Kontakte zu den Steckern vorgesehen sind, abweichen. Die Toleranzgrenze bei der Montage der bisher bekannten Sensorelemente kann daher mit 200 µm oder geringer angegeben werden.

Diese Anforderung an die Herstellungsmethode ist wirtschaftlich schwer realisierbar, zudem wird die Montage dadurch sehr kostspielig.

Deshalb ist es Aufgabe der vorliegenden Erfindung, ein Sensorelement mit einer Anordnung von Anschlussleitungen und Leitfähigkeitsbändern auf den elektrisch leitfähigen Schichten anzugeben, bei dem die Toleranzgrenze für die Montage der beiden elektrisch leitfähigen Schichten für das Kontaktieren der Anschlussleitungen mit den Steckern von dem eingangs erwähnten Werthoch gesetzt ist. Insbesondere ist es Aufgabe der vorliegenden Erfindung, ein Sensorelement anzugeben, das massenfertigungstauglich und preisgünstig herstellbar ist.

Gegenstand der vorliegenden Erfindung und Lösung der Aufgabe ist daher ein kapazitives Sensorelement gemäss den Merkmalen des Anspruch 1. Allgemeine Erkenntnis der Erfindung ist es, dass die Zusammenlegung der zu den Steckern im Randbereich führenden Anschlussleitungen auf einer einzigen elektrisch leitfähigen Schichtebene einen größeren Spielraum der Platzierung der einzelnen Lagen ermöglicht.

Nach einer vorteilhaften Ausführungsform ist vorgesehen, dass Leitfähigkeitsbänder, insbesondere die Stripe-Elektroden (3a,... 3k) alternierend mit einer Anschlussleitung (6) verbunden und nicht verbunden sind.

Nach einer weiteren vorteilhaften Ausführungsform ist vorgesehen, dass ein Abstand zwischen zwei benachbarten Leitfähigkeitsbändern, die Breite eines Leitfähigkeitsbandes mit umfassend oder nicht mit umfassend, auf einer elektrisch leitfähigen Schichtebene eine zu tolerierende Registerungenauigkeit beim Aufeinanderlegen einzelner, den Mehrschichtkörper bildenden, Lagen vorgibt.

Nach einer weiteren vorteilhaften Ausführungsform des Sensorelements ist vorgesehen, dass die Leitfähigkeitsbänder der Stripe-Elektroden periodisch in einem regelmäßigen Muster voneinander beabstandet vorliegen.

Die erste und/oder zweite elektrisch leitfähige Schicht weist vorzugsweise eine Schichtdicke zwischen 20 nm und 1 µm auf.

Bevorzugt ist die erste und/oder zweite elektrisch leitfähige Schicht hierbei aus einem transparenten, leitfähigen Material, vorzugsweise aus einer transparenten Folie, die mit einer dünnen und daher transparenten Schicht aus Silber oder Kupfer strukturiert beschichtet, beispielsweise bedruckt ist. Die erste und/oder zweite elektrisch leitfähige Schicht kann aber auch aus einem transparenten leitfähigen Material sein.

Nach einer vorteilhaften Ausführungsform liegen die Anschlussleitungen auf der ersten elektrisch leitfähigen Schicht mit den breiteren Leitfähigkeitsbändern, den so genannten "bar" Elektroden eines bar and stripes-Elektrodenmusters. Dabei ist es insbesondere vorteilhaft, wenn alle Anschlussleitungen auf dieser ersten, elektrisch leitfähigen Schicht liegen.

Insbesondere bevorzugt ist dabei die Ausführungsform, bei der die Leitfähigkeitsbänder, die nicht mit den Anschlussleitungen, die zu den Steckern führen, auf einer Ebene liegen, über Leitfähigkeits-Pads mit den Anschlussleitungen kontaktierend verbunden sind. Als "Leitfähigkeits-Pads" werden hier elektrisch leitfähige Bereiche einer ersten elektrisch leitfähigen Schicht bezeichnet, die über galvanischen Kontakt direkt mit Elektroden einer zweiten elektrisch leitfähigen Schicht verbunden sind.

In dem Fall, dass die Anschlussleitungen auf der ersten elektrisch leitfähigen Schicht liegen, ist ein Leitfähigkeits-Pad ein kleines Elektrodensegment, das innerhalb und/oder außerhalb des transparenten Bereichs des Sensorelements liegt und nicht durch die Isolatorschicht von der zweiten elektrisch leitfähigen Schicht galvanisch getrennt ist.

Nach einer vorteilhaften Ausführungsform liegen die schmäleren Leitfähigkeitsbänder, die Stripe-Elektroden auf der zweiten elektrisch leitfähigen Schicht.

Dabei kann es wiederum vorteilhaft sein, dass die Stripe-Elektroden als durchgehende Streifen leitfähigen Materials auf einem, bevorzugt transparenten, Endlosband aufgebracht sind. Diese Aufbringung der Streifen kann beispielsweise über Drucken, insbesondere in einem Rolle-zu-Rolle Verfahren, erfolgen.

Bei der Herstellung der Leitfähigkeitsbänder und/oder Anschlussleitungen durch Drucken ist es vorteilhaft, wenn ein bandartiges Trägermaterial aus flexiblem Kunststoff vorliegt, das im Rolle-zu-Rolle Verfahren mit leitfähigem Material bedruckbar ist.

Als wirtschaftlich besonders günstig hat sich erwiesen, wenn zumindest ein Leitfähigkeitsband in Laufrichtung eines Trägerbandes im Rolle-zu-Rolle Verfahren als Endlosstreifen gedruckt wird.

Nach einer weiteren Ausführungsform liegen die breiteren Bar-Elektroden-Leitfähigkeitsbänder in Laufrichtung des Bandes vor.

Bevorzugt weist die Isolatorschicht eine Schichtdicke im Bereich von 1 µm bis 200 µm auf, weiter bevorzugt zwischen 5µm und 100 µm. Die Isolatorschicht ist dielektrisch und besitzt vorzugsweise eine Dielektrizitätskonstante zwischen 2 und 4, weiter bevorzugt zwischen 2,5 und 3,5.

Als Trägermaterial wird insbesondere ein transparentes Trägermaterial bevorzugt. Dabei kommt beispielsweise eine Kunststofffolie, wie beispielsweise eine PET-Folie zum Einsatz.

Die Schichtdicke der Trägerfolie liegt beispielsweise zwischen 18 µm und 450 µm, insbesondere zwischen 50 und 300 µm und insbesondere bevorzugt zwischen 100 und 200 µm.

Als leitfähiges Material wird bevorzugt Material eingesetzt, das durch Bedrucken, insbesondere bevorzugt im Rolle-zu-Rolle Verfahren verarbeitbar ist. Beispielsweise können hier leitfähige, insbesondere auch metallische Pasten, alle leitfähigen Polymere und/oder die bekannten leitfähigen transparenten Metalloxide wie ITO und ATO, sowie, insbesondere bevorzugt, das aus der DE 10 2009 014 757.8 und/oder aus der DE 10 2011 115 851 bekannte transparente leitfähige Material "metal mesh" eingesetzt werden. Das sogenannte metal mesh Material zeichnet sich dadurch aus, dass es eine transparente Kunststofffolie mit dünnen Leiterbahnen aus nicht transparentem Material umfasst und für das menschliche Auge transparent ist. Die Leiterbahnen dieses flexiblen Materials zeichnen sich durch eine Breite im Bereich von 5 µm bis 25 µm aus und einer Belegung der transparenten Folie im Bereich zwischen 1 % und 20 %, bevorzugt im Bereich von 1 % bis 15 % Flächenbelegung. Das Material wird in den beiden oben genannten Patentanmeldungen beschrieben, deren Inhalt hiermit zur Offenbarung der vorliegenden Erfindung gemacht wird.

Gemäß einem bevorzugten Ausführungsbeispiel der Erfindung ist das Sensorelement als Touchscreen-Sensorelement ausgebildet, welches im Eingabebereich transparent für das menschliche Auge ausgebildet ist.

In diesem Fall besteht die dielektrische Isolatorschicht aus einem Material, welches in dem für das menschliche Auge sichtbaren Wellenlängenbereich transparent ist.

Weiter ist die erste und zweite elektrisch leitfähige Schicht für das menschliche Auge transparent ausgebildet, was zum einen durch die Verwendung eines entsprechend transparenten elektrisch leitfähigen Materials für die erste und/oder zweite elektrisch leitfähige Schicht und/oder durch entsprechende Wahl der Breite und Dicke der die Leitfähigkeit der Leitfähigkeitsbänder erzeugenden Leiterbahnen auf transparentem Träger, beispielsweise gemäß der aus der DE 10 2009 014 757.8 und/oder aus der DE 10 2011 115 851 bekannten Technik, realisiert werden kann. Insbesondere bevorzugt liegt die Breite dieser Leiterbahnen unterhalb des Auflösungsvermögens des menschlichen Auges, also bei einer Breite von weniger als 50 µm bevorzugt von weniger als 25 µm. Die Belegung mit Leiterbahnen pro Flächeneinheit innerhalb eines Leitfähigkeitsbandes liegt dabei zwischen 1 % und 20 %, insbesondere zwischen 1 % und 15 %.

Im Folgenden wird die Erfindung noch anhand von Figuren näher erläutert:
Figuren 1a und 1b zeigen ein Layout für die Anordnung von Leitfähigkeitsbändern gemäß dem Stand der Technik
Figuren 2a, 2b und 2c zeigen mit Figur 1 vergleichbare Ansichten gemäß einem Ausführungsbeispiel der vorliegenden Erfindung
Figur 2d zeigt einen Querschnitt dazu
Figuren 3 a und 3b zeigen Details zu den Leitfähigkeits-Pads aus Figur 2
Figuren 4 a und 4 b zeigen ein vergleichbares, aber um 90° gedrehtes Layout für die Anordnung von Leitfähigkeitsbändern nach einem weiteren Ausführungsbeispiel der Erfindung
Figur 5 a zeigt ein Detail zu einem Leitfähigkeits-Pad aus Figur 4
Figur 5b zeigt eine alternative Ausführungsform des Details zu einem Leitfähigkeits-Pad aus Figur 4

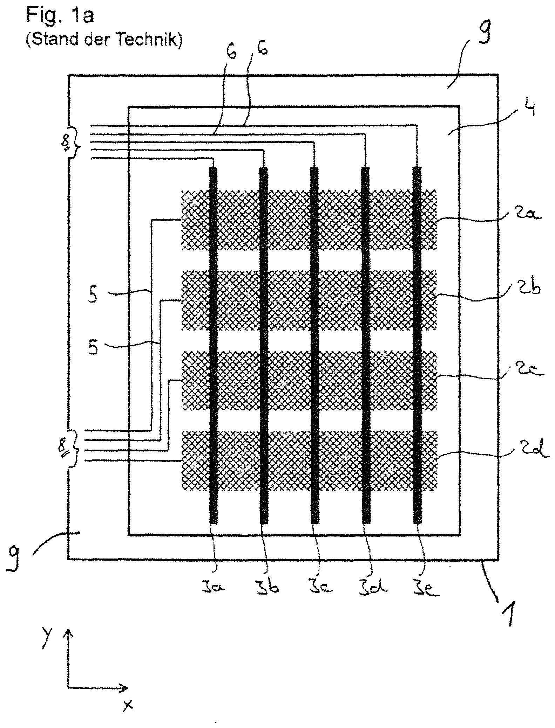

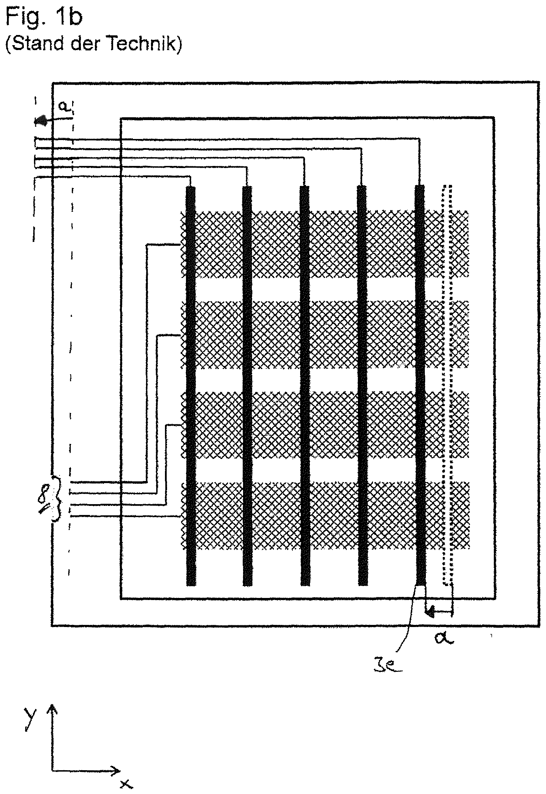

Figur 1 a zeigt den Stand der Technik eine "bars" und "stripes" Anordnung von Leitfähigkeitsbändern auf zwei übereinander liegenden, durch eine transparente dielektrische Isolatorfolie 4 galvanisch getrennten elektrisch leitfähigen Schichten 2 und 3 in unterschiedlichen Ebenen auf einem Folienträger 1. Die Isolatorfolie 4 umspannt hier den gesamten transparenten Eingabebereich des Sensorelements, der vom Randbereich 9 umgeben ist. Im außerhalb des transparenten Eingabebereichs liegenden Randbereich 9 führen die Anschlussleitungen 5 und 6 der Leitfähigkeitsbänder 2a... und 3a... zu den Anschlusssteckern 8, über die eine Kontaktierung zu einem entsprechenden Modul erfolgt. Damit die Anschlussleitungen 5 und 6 an die Stecker 8 kontaktierend eingreifen, müssen die Lagen der beiden elektrisch leitfähigen Schichten passgenau aufeinander liegen. Dies ist in Figur 1b verdeutlicht.

Figur 1b zeigt eine minimale Registerungenauigkeit "a" beim Aufeinanderlegen, beispielsweise Auflaminieren, der einzelnen Lagen der beiden elektrisch leitfähigen Schichten. Es kommt zu einer Verschiebung der Stripes-Elektroden 3 gegenüber den Bar-Elektroden 2 um die Länge "a". Dies wäre tolerabel, wenn nicht die Anschlüsse 6 der Stripes-Elektrodenschicht ebenfalls um ein Stück "a" versetzt im Randbereich enden würden. Nachdem aber die Anschlüsse 6 im Randbereich ebenfalls um die Strecke "a" versetzt enden, kann hier keine Kontaktierung über die Stecker 8 mehr erfolgen und somit kann eine Registerungenauigkeit der Dimension "a" nicht toleriert werden. Bei "a" handelt es sich um Längen von mindestens 100µm bis 200 µm oder mehr.

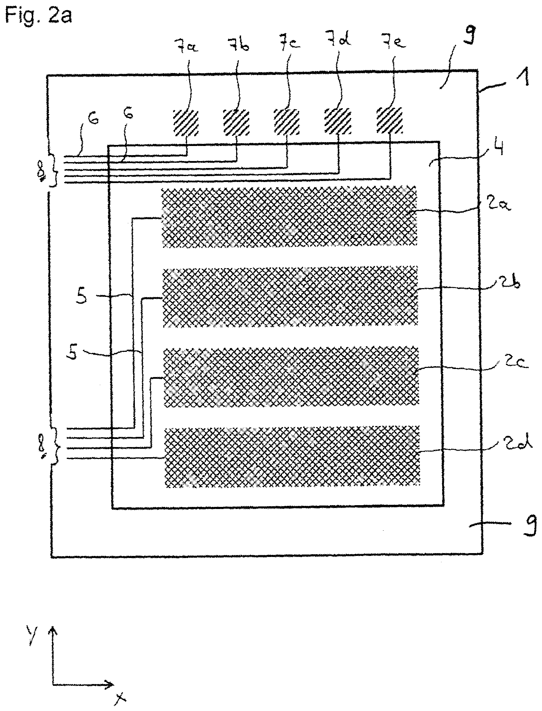

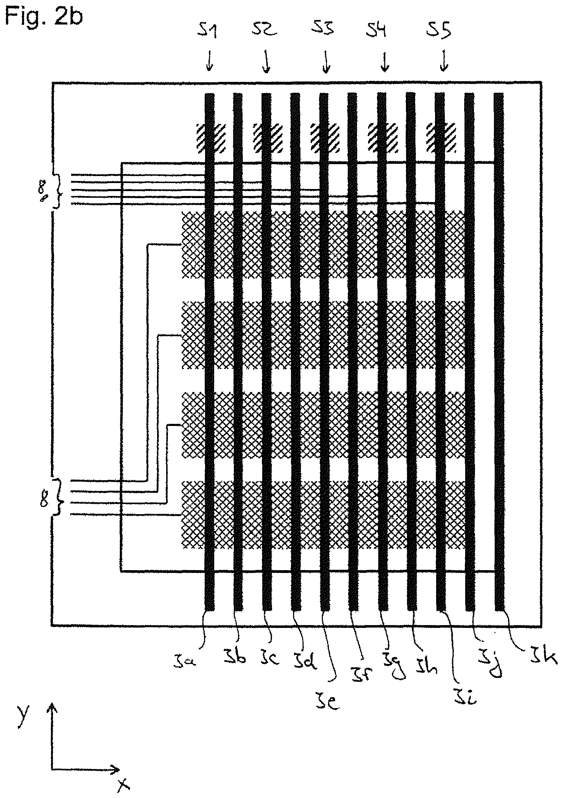

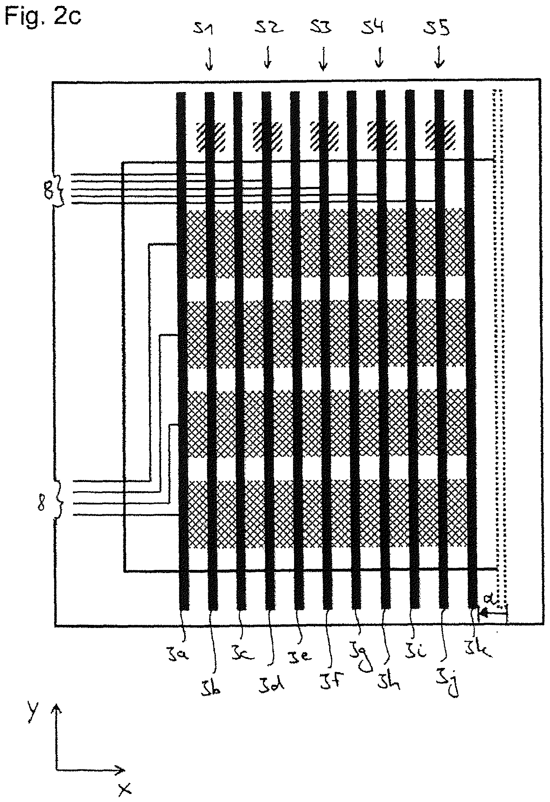

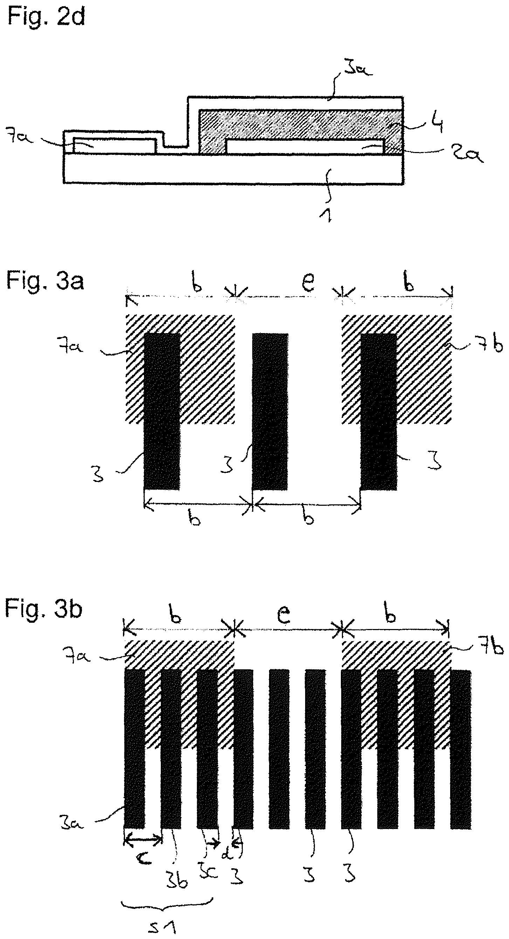

Figuren 2 zeigen, wie dieses Problem gemäß einer bevorzugten Ausführungsform der Erfindung gelöst wird. Figur 2a zeigt dazu lediglich die erste elektrisch leitfähige Schicht mit der Isolatorfolie 4 darauf. Zu erkennen sind die gleichen Bar-Elektroden 2a bis 2d, wie sie schon in Figur 1a zu erkennen waren. Diese Bar-Elektroden 2 a bis 2 d sind über die

Anschlussleitungen 5 mit einem Stecker 8 kontaktiert. Die Bar-Elektroden sind durch die Isolatorfolie 4 abgedeckt. Außerhalb der Abdeckung durch die Isolatorfolie 4 erkennt man auf der ersten elektrisch leitfähigen Schicht noch Leitfähigkeits-Pads 7 a bis 7e, die über Anschlussleitungen 6 mit einem weiteren Stecker 8 verbunden sind. Die Anschlussleitungen 6 sind hier, anders als bei Figur 1, die den Stand der Technik zeigt, auf der gleichen Schichtebene wie die Anschlussleitungen 5.

Die Anschlussleitungen 6 sind in dieser Ausführungsform zumindest teilweise durch die Isolatorfolie 4 abgedeckt, um Kurzschlüsse zu vermeiden.

Figur 2b zeigt das Gesamtbild entsprechend Figur 1a mit der zweiten, elektrisch leitfähigen, Schicht oberhalb der Isolatorfolie 4. Die zweite elektrisch leitfähige Schicht umfasst eine Vielzahl von Stripe-Elektroden 3a bis 3k, von denen nicht jede mit einer Anschlussleitung 6 gekoppelt ist. Praktisch ist jede zweite Stripe-Elektrode redundant, also nicht angeschlossen und daher überflüssig. Dieses Redundanz-Prinzip ermöglicht aber eine große Registertoleranz, weil mit der Stripe-Elektrodenschicht nach dieser Ausführungsform mit der Redundanz irgendeine Stripe-Elektrode schon passgenau zu liegen kommt und damit auch angeschlossen ist.

Die Stripe-Elektroden 3a bis 3k liegen zumindest zum Teil auf den Leitfähigkeits-Pads der ersten elektrisch leitfähigen Schicht, weil diese von der Isolatorfolie 4 nicht abgedeckt sind. Bei der in Figur 2b gezeigten Lage der zweiten elektrisch leitfähigen Schicht sind die Stripe-Elektroden 3a, 3c, 3e, 3g und 3i elektrisch kontaktiert. Somit sind die Stripe-Elektroden 3, die auf einem der Leitfähigkeits-Pads 7a bis 7 e der ersten elektrisch leitfähigen Schicht bei der Herstellung des Sensorelements zu liegen kommen, mit den Anschlussleitungen 6, die zu einem Stecker 8 führen, direkt elektrisch leitend verbunden.

Figur 2c zeigt eine vergleichbare Ansicht zu Figur 1b. Wegen der Schwierigkeiten beim Passgenauen-Übereinanderschichten der einzelnen elektrisch leitfähigen Schichten kann sich auch hier eine Verschiebung der zweiten elektrisch leitfähigen Schicht gegenüber der ersten elektrisch leitfähigen Schicht um die Länge "a" ergeben. Wie gleich auf den ersten Blick erkennbar, hat diese aber keinerlei Auswirkung auf die Kontaktierung durch die Stecker 8 mehr, da die Anschlussleitungen 5 und 6 zu den Steckern 8 alle auf einer Schichtebene liegen und somit passgenau zu den Steckern 8.

Gemäß der Figur 2c sind nur noch die Stripe-Elektroden 3b, 3d, 3f, 3h und 3j über die Leitfähigkeits-Pads 7a bis 7e und den Anschlussleitungen 6 an die Stecker 8 und damit an die angesteuerten Module angeschlossen.

Die gemäß Figur 2b kontaktierten Stripe-Elektroden 3a, 3c, 3g, 3i und 3k liegen außerhalb der Leitfähigkeits-Pads 7a bis 7e auf der ersten Elektrodenschicht und führen somit zu keiner Anschlussleitung 6 mehr. Diese Stripe-Elektroden sind demgemäß redundant und tragen zur Funktion des Sensorelements nicht bei. Für die Massenfertigungstauglichkeit des Sensorelements sind sie jedoch entscheidend, da die redundant vorhandenen Elektroden bei der Herstellung einen Freiraum bezüglich der notwendigen Registertoleranz schaffen. Hinzu kommt, dass die redundanten Leitfähigkeitsbänder auch nicht stören, vielmehr können sie optisch zu einem homogeneren Erscheinungsbild beitragen, sowie zur vereinheitlichten Transmission.

Insbesondere bevorzugt ist eine Ausführungsform, bei der die redundanten Leitfähigkeitsbänder in immer gleichem Abstand, also mit Periodizität, aufgebracht sind.

Die Leitfähigkeitsbänder der elektrisch leitfähigen Schichten, also insbesondere Bar-Elektroden 2a bis 2d und Stripe-Elektroden 3a bis 3k können in unterschiedlichen Größen gebildet sein und sich über unterschiedliche Bereiche des Sensorelements erstrecken. Beispielsweise verlaufen diese Bar- und Stripe-Elektroden zumindest über den transparenten Bereich eines Sensorelements, können aber auch beliebig weit über den, unter Umständen nicht transparenten Randbereich des Sensorelements oder über mehrerer Sensorelemente hin ausgedehnt sein, bis hin zur längsten Ausbildung, der durchgehenden Ausführung, bei der sie bis hin zum kompletten Bandmaterial eines Rolle-zu-Rolle-Druckprozesses als Endlosstreifen ausgebildet sind. Zur Herstellung des Sensorelements werden zwei oder mehrere bedruckte Bänder entsprechend geschnitten, zu einem Mehrschichtkörper aufeinander gelegt und verbunden und/oder zusammenlaminiert.

Nach einer bevorzugten Ausführungsform der Erfindung verlaufen die Stripe-Elektroden 3 entlang der Druckrichtung. Dies ist insbesondere beim Rolle-zu-Rolle-Druckverfahren vorteilhaft, wenn in einem Endlosdruck auf der gesamten Länge des Trägerbandes Stripe-Elektroden kosteneffizient aufgedruckt werden. Dies kann sowohl für die Ausführungsform der Erfindung, bei der redundante Stripe-Elektroden vorgesehen sind, als auch bei der Ausführungsform der Erfindung ohne redundante Stripe-Elektroden, realisiert sein. In jedem Fall ziehen sich dabei die Stripe-Elektroden in Druckrichtung über die ganze Länge des Druckbandes hin.

Figur 2d zeigt einen Querschnitt durch einen Ausschnitt eines Sensorelements nach einer in Figur 2 gezeigten Ausführungsform der Erfindung. Zu erkennen ist ein Querschnitt durch das Leitfähigkeits-Pad 7a aus Figur 2b auf dem Träger 1, entlang der Stripe-Elektrode 3a über die Bar-Elektrode 2a hinweg. Zu sehen ist insbesondere auch die Lage der Isolatorfolie 4, die die Stripe-Elektrode 3a von der Bar-Elektrode 2a galvanisch abtrennt, nicht aber das Leitfähigkeits-Pad 7a, das auf gleicher Ebene wie die Bar-Elektrode 2a liegt, von der Stripe-Elektrode 3a, die daran direkt anschließt.

Figur 3a und 3b zeigen verschiedene Grade der Redundanz. In Figur 3a ist der Abstand "b" zwischen den Stripe-Elektroden 3 gleich dem Abstand zwischen den Leitfähigkeits-Pads 7a und 7b. Auch die Breite der Leitfähigkeits-Pads 7a und 7b entspricht dieser Länge "b". Auf diese Art ist sichergestellt, dass immer eine einzige Stripe-Elektrode 3 mit einem der Leitfähigkeits-Pads 7 verbunden ist. Die Länge "b" aus den Figuren 2b und 3a gibt daher die Periodizität der redundanten Stripe-Elektroden und die Breite einer Spalte S1 bis S5 wieder. Die Länge "e" zeigt den Abstand zweier Leitfähigkeits-Pads voneinander.

Figur 3b zeigt schematisch eine andere bevorzugte Konfiguration. Der Abstand "c" zwischen den Stripe-Elektroden 3 ist erheblich kleiner als die Breite der Spalten S1 bis S5 und als die Breite und der Abstand der Leitfähigkeits-Pads. Auf diese Art wird beispielsweise die Spalte S1 (Figur 2b) durch die Stripe-Elektroden 3a bis 3c gemeinsam ausgebildet.

Bei einer angenommenen Breite "b" eines Leitfähigkeits-Pads können 1 bis 10 Stripe-Elektroden, bevorzugt 1 bis 7 Stripe-Elektroden untergebracht sein. Die Breite "b" entspricht beispielsweise der Breite einer Stripe-Elektrode nach dem Stand der Technik (Figur 1a). "b" kann beispielsweise im Bereich von 0,5 bis 3 mm, beispielsweise bei 2 mm, liegen.

Die Länge "c", die den Abstand zweier benachbarter Stripe-Elektroden plus die Breite einer Stripe-Elektrode umfasst, liegt beispielsweise im Bereich zwischen 0,1 bis 5 mm, bevorzugt zwischen 0,2 bis 3 mm, insbesondere bevorzugt zwischen 0,4 mm und 1 mm. Die Länge "c" entspricht der Periodizität der redundant angeordneten Elektroden.

Die Länge "d", die nur den Abstand zweier benachbarter Stripe-Elektroden beschreibt, liegt beispielsweise im Bereich zwischen 5 µm und 20µm, gerade passend um eine galvanische Trennung zwischen zwei benachbarten Leitfähigkeitsbändern zu gewährleisten.

Der Abstand "e" zwischen zwei benachbarten Leitfähigkeits-Pads ist abhängig von der Größe der Sensorfelder, er kann beispielsweise im Bereich von 1 bis 10 mm liegen, vorteilhafterweise im Bereich von 2 bis 8 mm und insbesondere bei ca. 4 bis 5 mm.

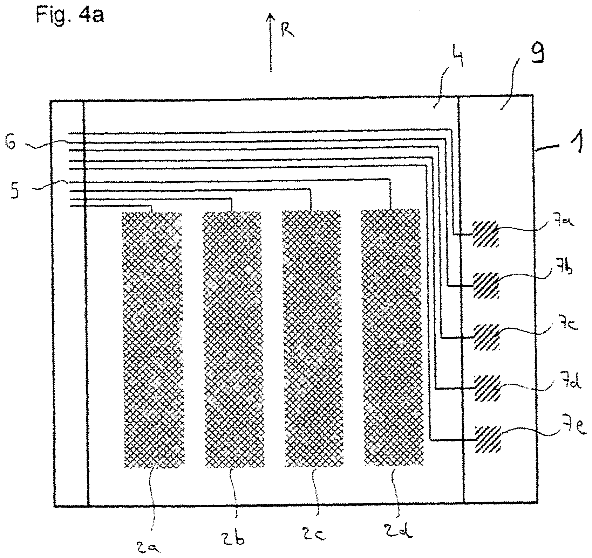

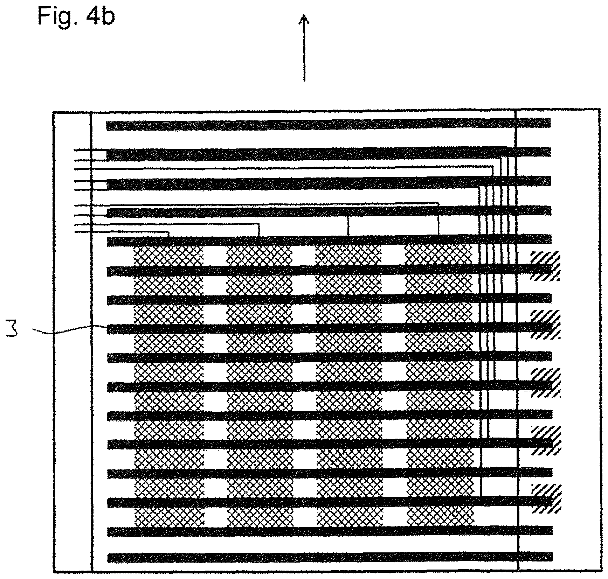

Die Figuren 4a und 4b zeigen ein weiteres Ausführungsbeispiel, welches bei einem kontinuierlichen Rolle-zu-Rolle Druckprozess von hoher prozesstechnischer Relevanz ist. Bei dem Ausführungsbeispiel gemäß der Figur 2 deckt die Isolatorfolie 4 zwar die Bar-Elektroden 2a bis 2d und die Anschlussleitungen 6 ab, nicht jedoch die Leitfähigkeits-Pads 7a bis 7e, die außerhalb des Eingabebereichs 4 im - nicht notwendigerweise transparenten - Randbereich 9 liegen.

Entsprechend wird bei dem Ausführungsbeispiel gemäß Figur 2 die Isolatorschicht 4 strukturiert aufgebracht. Demgegenüber steht das in Figur 4 gezeigte Ausführungsbeispiel, wo die Isolatorfolie 4 im Endlos-Verfahren ohne Strukturierung aufbringbar ist, weil die Leitfähigkeits-Pads 7a bis 7e außerhalb der Bandbreite der Isolatorfolie 4 in Laufrichtung "R" des bedruckbaren Trägerbands liegen. Entsprechend diesem Ausführungsbeispiel werden die Bar-Elektroden 2a bis 2d in Laufrichtung des Trägerbandes aufgebracht, beispielsweise gedruckt.

Figur 4b zeigt das vollständige Sensorelement mit den die Bar-Elektroden überlagernden Stripe-Elektroden 3, die im Bereich der Anschlussleitungen 5 und 6, wie aus Figur 4a ersichtlich, durch die kontinuierlich durchgehende Isolatorfolie 4 galvanisch abgetrennt sind. Die Stripe-Elektroden 3 sind in der hier gezeigten Ausführungsform sowohl im Bereich der Bar-Elektroden 2a bis 2d als auch im Bereich der Anschlussleitungen 5 und 6 redundant, als Stripe-Elektroden 3' aufgebracht. Dies kann prozesstechnisch kosteneffizienter als eine strukturierte Aufbringung sein und, wie oben bereits erwähnt, stört die Funktionalität nicht, sondern verbessert unter Umständen sogar die Optik.

Die Kontaktierung der Leitfähigkeits-Pads 7 bei gleichzeitiger Isolierung der Anschlüsse 6 kann zum einen durch eine Strukturierung des Isolatorfolie 4 erfolgen, zum anderen aber auch durch einen Ersatz des Isolatormaterials 4 an den Stellen der Leitfähigkeits-Pads 7 durch eine leitfähige Durchkontaktierung und/oder ein leitfähiges Klebematerial.

Insbesondere ist es auch möglich, die erste elektrisch leitfähige Schicht mit den Bar-Elektroden 2a bis 2d und die zweite elektrisch leitfähige Schicht mit den Stripe-Elektroden 3a bis 3k über eine als Klebeschicht ausgeführte Isolatorschicht 4 zu verbinden, beispielsweise zusammen zu laminieren, wobei im Bereich der Leitfähigkeits-Pads ein sogenannter "anisotropic conductive film"-Kleber gleichzeitig aufgebracht wird. Dieser Leitfähigkeits-Kleber kann, zusammen mit dem isolierenden Kleber zur Ausbildung der Isolatorfolie 4 prozesstechnisch wieder über die gesamte Breite des Druckbandes aufgedruckt werden.

Im Bereich zwischen den Leitfähigkeits-Pads 7 und den Stripe-Elektroden 3, respektive den Bar-Elektroden 2 - je nach Ausführungsform - ist entweder kein Material oder elektrisch leitfähiges Material vorgesehen.

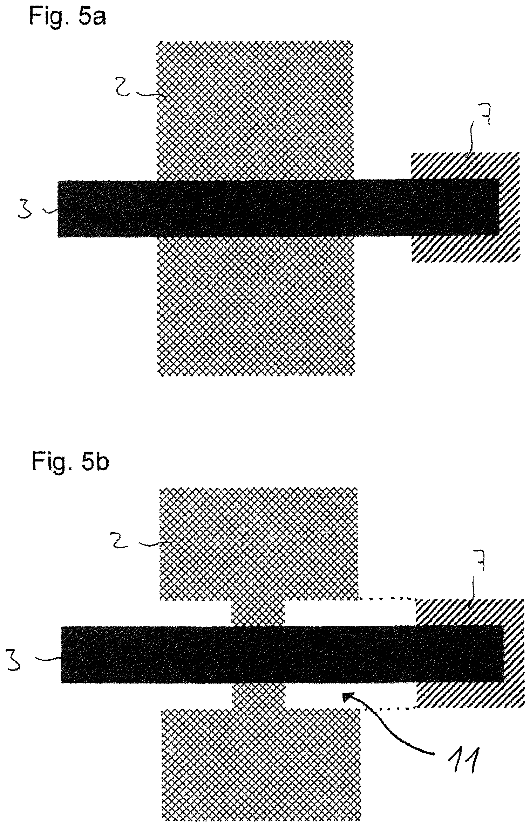

Figuren 5a und 5b zeigen den Bereich A aus Figur 4b im Detail. Dabei ist in Figur 5a (Draufsicht wie in Figur 4b) zu erkennen, wie die Stripe-Elektrode 3 die darunter liegende, aber durch Isolatorfolie 4 (hier nicht gezeigt) getrennte Bar-Elektrode 2 kreuzt und dann mit dem Leitfähigkeits-Pad 7 kontaktiert. Vom Leitfähigkeits-Pad 7 aus geht eine Anschlussleitung 6 (hier nicht gezeigt) zum Stecker 8 (ebenfalls der Übersichtlichkeit halber nicht gezeigt).

Die Bar-Elektrode 2 ist in Figur 5a als vollständiges Rechteck ausgeführt. In Figur 5b ist eine weitere Ausführungsform gezeigt, bei der die Bar-Elektrode 2 sich im Kreuzungsbereich mit der Stripe-Elektrode 3 verjüngt. Dies bedingt einen verbesserten, da Raumausgreifenderen Feldlinienverlauf und folglich eine erhöhte Zuverlässigkeit bei der Auslesung einer Eingabe. Diese Verjüngung bildet zumindest einen Spalt 11 aus, der für eine Optimierung des Feldlinienverlaufs passgenau die Breite eines Leitfähigkeitspads 7, der in der gleichen Schichtebene liegt, einnimmt.

Die in Figur 5b gezeigte Ausführungsform ist bei der Erfindung besonders bevorzugt, da sie nur bei dem hier erstmals vorgestellten Layout sinnvoll einsetzbar ist, wo eine erhöhte Toleranz der Registergenauigkeit, insbesondere bei einer redundanten Aufbringung von Elektroden, gewährleistet ist.

Die Erfindung stellt ein Layout mit redundanten Leitfähigkeitsbändern für eine Anordnung von sich kreuzenden Leitfähigkeitsbändern zur Verfügung, durch das die Anforderung an die Registergenauigkeit bei der zweilagigen Laminierung von Schichtelektroden herabgesetzt wird, insbesondere im Hinblick auf die Verbindung der Anschlussleitungen mit den Steckern im Randbereich eines, ein entsprechendes Sensorelement einsetzenden, Moduls.

## Patentansprüche

1. Kapazitives Sensorelement (1), zumindest einen Mehrschichtkörper aus zwei strukturierten elektrisch leitfähigen Schichten (2,3) und dazwischen eine Isolatorschicht (4) umfassend,
**dadurch gekennzeichnet, dass** die Strukturierung einer elektrisch leitfähigen ersten sowie einer zweiten Schicht jeweils voneinander galvanisch getrennte Leitfähigkeitsbänder (2a, 2b, 2c, 2d, 3a,... 3k) aufweist, von denen Leitfähigkeitsbänder (2a, 2b, 2c, 2d, 3a,... 3k) einer der beiden Schichten (2,3) nur zum Teil über Leitfähigkeitspad (7a bis 7e) mit ihren Anschlussleitungen (5, 6) verbunden sind so dass die Anschlussleitungen (5,6) der ersten und der zweiten elektrisch leitfähigen Schicht (2,3) sowie die Leitfähigkeitspads (7a bis 7e) zusammen mit den anderen Leitfähigkeitsbändern (2a, 2b, 2c, 2d, 3a, ...3k) auf einer Ebene liegen und die Isolatorschicht (4) die beiden strukturierten elektrisch leitfähigen Schichten (2,3) nicht vollflächig voneinander trennt, so dass die Leitfähigkeitspads (7a bis 7e) nicht von der Isolatorschicht (4) bedeckt werden.

2. Sensorelement nach Anspruch 1, wobei ein Abstand ("b") oder ("c") zwischen zwei benachbarten Leitfähigkeitsbändern ausgebildet als Stripe-Elektroden (3a,... 3k) die Periodizität vorgibt, in der an Anschlussleitungen angeschlossene und nicht angeschlossene Leitfähigkeitsbänder wie die Stripe-Elektroden (3a...3k) auf einer elektrisch leitfähigen Schicht nebeneinander liegen.

3. Sensorelement nach einem der vorstehenden Ansprüche, wobei die Leitfähigkeitsbänder (2a, 2b, 2c, 2d, 3a,... 3k), die nicht mit den Anschlussleitungen (5,6), die zu Steckern (8) führen, auf einer Ebene liegen, über Leitfähigkeits-Pads (7a bis 7e) mit den Anschlussleitungen (5,6) kontaktierend verbunden sind.

4. Sensorelement nach einem der vorstehenden Ansprüche, das einen Bereich umfasst, der transparent ausgebildet ist.

5. Sensorelement nach einem der vorstehenden Ansprüche, wobei zumindest ein Leitfähigkeits-Pad vorgesehen ist, das innerhalb des transparenten Bereichs des Sensorelements liegt.

6. Sensorelement nach einem der vorstehenden Ansprüche, wobei ein Leitfähigkeits-Pad vorgesehen ist, das außerhalb des transparenten Bereichs des Sensorelements liegt.

7. Sensorelement nach einem der vorstehenden Ansprüche, das zumindest eine Lage umfasst, die durch Bedrucken eines Trägerbandes (1) herstellbar ist.

8. Sensorelement nach einem der vorstehenden Ansprüche, das durch Laminieren mehrerer Lagen herstellbar ist.

9. Sensorelement nach einem der vorstehenden Ansprüche, das durch Auflaminieren einer zweiten elektrisch leitfähigen Schicht (3) auf eine erste elektrisch leitfähige Schicht (2) mittels einer strukturiert aufgebrachten isolierenden Klebeschicht (4) herstellbar ist.

10. Sensorelement nach einem der vorstehenden Ansprüche, bei dem die ersten Leitfähigkeitsbänder (2a bis 2d) im Bereich der Kreuzungspunkte mit den zweiten Leitfähigkeitsbändern (3a bis 3k) Spalten (11) aufweisen, die nicht leitfähige Bereiche sind.

11. Sensorelement nach einem der vorstehenden Ansprüche, wobei die Spalten (11) in den Dimensionen an die Leitfähigkeits-Pads (7a bis 7e) angepasst sind.

12. Verfahren zur Herstellung eines Sensorelements nach einem der Ansprüche 1 bis 11 durch Aufeinanderlaminieren zumindest zweier elektrisch leitfähiger Schichten mit dazwischen einer isolierenden Schicht.

## Claims

1. Capacitive sensor element (1), comprising at least one multilayer body made of two structured electrically conductive layers (2, 3) and an insulating layer (4) therebetween, **characterised in that** the structuring of an electrically conductive first and a second layer each has conductivity strips (2a, 2b, 2c, 2d, 3a, ... 3k) which are each galvanically separated from one another, of which conductivity strips (2a, 2b, 2c, 2d, 3a, ... 3k) of one of the two layers (2, 3) are only partially connected via conduction pad (7a to 7e) to their connecting leads (5, 6), so that the connecting leads (5, 6) of the first and the second electrically conductive layer (2, 3) and the conduction pads (7a to 7e), along with the other conductivity strips (2a, 2b, 2c, 2d, 3a, ...3k), lie on a plane and the insulating layer (4) does not completely separate the two structured electrically conductive layers (2, 3), so that the conduction pads (7a to 7e) are not covered by the insulating layer (4).

2. Sensor element according to claim 1, wherein a distance ("b") or ("c") between two adjacent conductivity strips formed as stripe electrodes (3a...3k) specifies the periodicity in which conductivity strips such as the stripe electrodes (3a...3k), which are connected and unconnected to connecting leads, lie side-by-side on an electrically conductive layer.

3. Sensor element according to one of the preceding claims, wherein the conductivity strips (2a, 2b, 2c, 2d, 3a, ... 3k), which do not lie on a plane with the connecting leads (5, 6) leading to sockets (8), are connected to the connecting leads (5, 6) via conduction pads (7a to 7e) in a contact-making manner.

4. Sensor element according to one of the preceding claims, comprising a region which is formed transparently.

5. Sensor element according to one of the preceding claims, wherein at least one conduction pad lying within the transparent region of the sensor element is provided.

6. Sensor element according to one of the preceding claims, wherein a conduction pad lying outside the transparent region of the sensor element is provided.

7. Sensor element according to one of the preceding claims, comprising at least one sheet which is producible by imprinting of a carrier strip (1).

8. Sensor element according to one of the preceding claims, which is producible by laminating several sheets.

9. Sensor element according to one of the preceding claims, which is producible by laminating a second electrically conductive layer (3) onto a first electrically conductive layer (2) by means of an isolating adhesive layer (4) which is applied in a structured manner.

10. Sensor element according to one of the preceding claims, in which the first conductivity strips (2a to 2d) have gaps (11), which are non-conductive regions, in the region of the crossover points with the second conductivity strips (3a to 3k).

11. Sensor element according to one of the preceding claims, wherein the gaps (11) are adapted to the dimensions of the conduction pads (7a to 7e).

12. Method for producing a sensor element according to one of claims 1 to 11 by laminating at least two electrically conductive layers to one another with an isolating layer therebetween.

## Revendications

1. Elément de détection (1) capacitif, comprenant au moins un corps multicouche composé de deux couches (2, 3) électroconductrices structurées et, de manière intercalée, une couche isolante (4),
**caractérisé en ce que** la structuration d'une première ainsi que d'une seconde couche électroconductrice présente des bandes de conductivité (2a, 2b, 2c, 2d, 3a, ..., 3k) séparées de manière galvanique respectivement les unes des autres, parmi lesquelles des bandes de conductivité (2a, 2b, 2c, 2d, 3a, ..., 3k) d'une des deux couches (2, 3) sont reliées seulement en partie par l'intermédiaire d'une voie de conductivité (7a à 7e) à leurs lignes de raccordement (5, 6) de sorte que les lignes de raccordement (5, 6) de la première et de la seconde couche (2, 3) électroconductrice ainsi que les voies de conductivité (7a à 7e) se trouvent conjointement avec les autres bandes de conductivité (2a, 2b, 2c, 2d, 3a, ..., 3k) sur un plan et la couche isolante (4) ne sépare pas complètement les deux couches (2, 3) électroconductrices structurées de sorte que les voies de conductivité (7a à 7e) ne sont pas couvertes par la couche isolante (4).

2. Elément de détection selon la revendication 1, dans lequel une distance (« b ») ou (« c ») entre deux bandes de conductivité adjacentes réalisées sous la forme d'électrodes en bande (3a, ..., 3k) spécifie la périodicité, selon laquelle des bandes de conductivité raccordées et non raccordées aux lignes de raccordement telles que les électrodes en bande (3a, ..., 3k) se situent les unes à côté des autres sur une couche électroconductrice.

3. Elément de détection selon l'une quelconque des revendications précédentes, dans lequel les bandes de conductivité (2a, 2b, 2c, 2d, 3a, ..., 3k), qui ne se situent pas sur un plan avec les lignes de raccordement (5, 6), qui mènent aux connecteurs (8), sont reliées de manière à établir un contact aux lignes de raccordement (5, 6) par l'intermédiaire de voies de conductivité (7a à 7e).

4. Elément de détection selon l'une quelconque des revendications précédentes, qui comprend une zone qui est réalisée de manière transparente.

5. Elément de détection selon l'une quelconque des revendications précédentes, dans lequel est prévue au moins une voie de conductivité, qui se trouve à l'intérieur de la zone transparente de l'élément de détection.

6. Elément de détection selon l'une quelconque des revendications précédentes, dans lequel est prévue une voie de conductivité, qui se trouve à l'extérieur de la zone transparente de l'élément de détection.

7. Elément de détection selon l'une quelconque des revendications précédentes, qui comprend au moins une strate, qui peut être produite par l'impression d'une bande de support (1).

8. Elément de détection selon l'une quelconque des revendications précédentes, qui peut être produit par le laminage de plusieurs strates.

9. Elément de détection selon l'une quelconque des revendications précédentes, qui peut être produit par l'application par laminage d'une seconde couche (3) électroconductrice sur une première couche (2) électroconductrice au moyen d'une couche adhésive (4) isolante appliquée de manière structurée.

10. Elément de détection selon l'une quelconque des revendications précédentes, dans lequel les premières bandes de conductivité (2a à 2d) présentent, dans la zone des points d'intersection avec les deuxièmes bandes de conductivité (3a à 3k), des fentes (11), qui ne sont pas des zones conductrices.

11. Elément de détection selon l'une quelconque des revendications précédentes, dans lequel les fentes (11) sont adaptées dans les dimensions aux voies de conductivité (7a à 7e).

12. Procédé servant à produire un élément de détection selon l'une quelconque des revendications 1 à 11, par le laminage les unes sur les autres d'au moins deux couches électroconductrices avec, de manière intercalée, une couche isolante.
